# DEMANDE DE BREVET EUROPEEN

(11) **EP 1 261 030 A1**
(43) Date de publication de la demande: **27.11.2002**
(21) Numéro de dépôt: 02291127.5
(22) Date de dépôt: 06.05.2002
(51) Int. Cl.: H01L 23/485

(54) **Plot de connexion d'un circuit intégré**

(30) Priorité: 18.05.2001 FR 0106591
(71) Demandeur: STMicroelectronics S.A., 92120 Montrouge (FR)
(72) Inventeur: Varrot, Michel, 38190 Bernin (FR); Bouche, Guillaume, 38000 Grenoble (FR); Gonella, Roberto, 38240 Meylan (FR); Sabouret, Eric, 38000 Grenoble (FR)
(74) Mandataire: Casalonga, Axel

(57) **Abrégé**

Chaque plot de connexion PLC comporte :
- une couche métallique supérieure continue CMS située au niveau de métallisation supérieur et comportant sur sa face supérieure une zone pour le soudage d'un fil de connexion, et
- une structure de renfort STR située sous la zone de soudage et comportant au moins une couche métallique discontinue CMD4 située au niveau de métallisation immédiatement inférieur, des vias métalliques VS reliant cette couche métallique discontinue à la surface inférieure de la couche métallique supérieure, et un enrobage isolant OX enrobant ladite couche métallique discontinue et ses discontinuités ainsi que les espaces intervias entre ces deux couches métalliques.

## Description

L'invention concerne les circuits intégrés, et plus particulièrement la structure des plots de connexion ("pads" en langue anglaise).

Les plots de connexion du circuit intégré, qui sont généralement disposés à la périphérie de celui-ci, forment les bornes d'entrée/sortie de ce circuit intégré. Comme il est classique en la matière, le circuit intégré est encapsulé dans un boîtier en résine qui maintient également les pattes métalliques qui seront destinées à être soudées sur une carte électronique. La liaison entre les plots de connexion du circuit intégré et les pattes métalliques est effectuée par des fils de connexion généralement en or et parfois en aluminium, soudés à la fois sur les pattes métalliques et sur la surface supérieure métallique des plots de connexion.

Or, avec les structures habituellement utilisées pour les plots de connexion, l'opération de soudure d'un fil sur la surface supérieure du plot de connexion induit un risque de délamination ainsi qu'un risque d'apparition de microfissures dans la structure du plot de connexion en raison des fortes contraintes appliquées, soit sur la boule d'or permettant la soudure, soit lors de l'écrasement du fil d'aluminium. Ce risque, même s'il est maîtrisé et contrôlé pour les technologies actuellement utilisées, nécessite toutefois des contraintes supplémentaires au niveau des machines de soudure, notamment des réglages au cas par cas des paramètres de la soudure.

Par ailleurs, ce risque de délamination et d'apparition de microfissures est d'autant plus élevé que la taille des plots de connexion est petite, en particulier pour une technologie 0,18 µm, voire moins.

L'invention vise à apporter une solution à ce problème.

Un but de l'invention est de proposer une structure de plot de connexion qui minimise encore davantage, voire supprime, les risques de délamination et d'apparition de microfissures, et ce même pour des technologies avancées, en particulier pour des technologies 0,18 µm et moins, pour lesquelles la taille de la boule d'or déposée sur la surface supérieure du plot de connexion est de taille particulièrement réduite.

L'invention a également pour but de proposer un plot de connexion compatible structurellement avec de nombreuses applications dont des applications radiofréquence.

L'invention propose donc un circuit intégré comprenant plusieurs niveaux de métallisation ainsi que des plots de connexion, dans lequel chaque plot de connexion comporte
- une couche métallique supérieure continue située au niveau de métallisation supérieur du circuit intégré, et comportant sur sa face supérieure une zone pour le soudage d'un fil de connexion, et
- une structure de renfort située sous la zone de soudage et comportant au moins une couche métallique discontinue située au niveau de métallisation immédiatement inférieur, des vias métalliques reliant cette couche métallique discontinue à la surface inférieure de la couche métallique supérieure, et un enrobage isolant enrobant ladite couche métallique discontinue et ses discontinuités ainsi que les espaces intervias entre ces deux couches métalliques.

D'une façon générale, la couche métallique discontinue s'entend avantageusement comme étant formée de discontinuités métalliques distinctes et mutuellement séparées.

La demanderesse a en effet observé que la combinaison d'une couche métallique discontinue, de vias métalliques reliant cette couche discontinue à la couche supérieure, le tout enrobé dans un enrobage isolant, par exemple du dioxyde de silicium, formait une structure de renfort mécaniquement résistante aux contraintes appliquées lors de l'opération de soudage. En effet, les vias réalisent une fonction d'accrochage de la couche supérieure sur l'isolant, ce qui contribue à minimiser le risque de délamination, tandis que la couche discontinue compense les faiblesses de l'enrobage isolant introduites par les vias et minimise notamment l'apparition de microfissures.

Bien que la couche métallique discontinue puisse être formée de différentes façons, il est particulièrement avantageux qu'elle soit formée de motifs élémentaires discontinus régulièrement répartis, par exemple formés chacun de plusieurs bandes métalliques distinctes parallèles, chaque bande métallique supportant alors plusieurs vias métalliques distincts.

Par ailleurs, dans le but d'éviter de conférer une direction privilégiée aux discontinutés de la couche métallique, ce qui pourrait s'avérer gênant si cette direction privilégiée correspond à la direction générale de vibration du plot de connexion lors de l'opération de soudage par ultrasons, il est préférable que les orientations générales respectives de deux motifs adjacents soient différentes, par exemple orthogonales.

Par ailleurs, bien qu'il soit possible d'utiliser la structure de renfort, notamment la couche métallique discontinue et les vias pour former également une connexion électrique éventuelle entre le fil de connexion et des niveaux de métallisation inférieurs du circuit intégré, il est particulièrement avantageux, notamment pour éviter de conférer une valeur capacitive trop élevée au plot de connexion (ce qui est particulièrement intéressant dans des applications radiofréquence), de prévoir que le plot de connexion comporte une couronne périphérique métallique située au même niveau de métallisation que celui de la couche métallique discontinue, entourant cette couche métallique discontinue et électriquement isolé de celle-ci par l'enrobage isolant. Par ailleurs, des vias périphériques métalliques relient alors cette couronne périphérique à une zone périphérique de la surface inférieure de la couche métallique supérieure.

Par ailleurs, afin de pouvoir permettre un contact électrique à n'importe quel niveau de métallisation du circuit intégré, le plot de connexion peut comporter plusieurs couronnes périphériques métalliques empilées et s'étendant respectivement à des niveaux de métallisation différents, chaque couronne périphérique étant reliée à la couronne immédiatement adjacente par des vias périphériques métalliques.

La structure de renfort peut ne comporter qu'une seule couche métallique discontinue située immédiatement sous la couche métallique supérieure du plot de connexion. Dans ce cas, l'enrobage isolant du plot de connexion peut s'étendre jusqu'au niveau du substrat de circuit intégré. Une telle architecture est alors particulièrement intéressante dans le cas d'applications radiofréquence, car elle confère également une valeur capacitive relativement faible au plot de connexion.

Ceci étant, dans d'autres applications, la structure de renfort peut comporter plusieurs couches métalliques discontinues empilées et s'étendant respectivement à des niveaux de métallisation différents, mutuellement reliées par des vias métalliques. L'enrobage isolant enrobe alors en outre chaque couche métallique discontinue et ses discontinuités ainsi que les espaces intervias entre deux couches métalliques discontinues adjacentes.

Toujours dans le but d'augmenter la résistance mécanique de la structure, notamment lors des vibrations résultant de l'opération de soudure assistée par ultrasons, il est avantageux que deux motifs superposés appartenant respectivement à deux couches métalliques discontinues adjacentes soient mutuellement décalés ou bien aient des orientations générales respectives différentes, par exemple orthogonales.

Les couches métalliques du plot de connexion peuvent être en aluminium et les vias en tungstène. Ceci étant, il est également possible que les couches métalliques et les vias soient en cuivre. Cependant, dans ce cas, la discontinuité de chaque couche métallique discontinue est avatageusement choisie de telle sorte que la densité de cuivre soit comprise entre environ 20% et environ 80% dans une fenêtre de 50 µm x 50 µm, et ce afin d'être compatible avec un polissage mécano-chimique qui est une étape utilisée pour le procédé de réalisation des lignes et des vias (procédé damascène).

D'autres avantages et caractéristiques de l'invention apparaîtront à l'examen de la description détaillée de modes de réalisation, nullement limitatifs, et des dessins annexés, sur lesquels :
- la figure 1 illustre schématiquement un circuit intégré selon l'invention, équipé de plots de connexion;
- la figure 2 illustre plus particulièrement un mode de réalisation d'un plot de connexion selon l'invention;
- la figure 3 illustre plus précisément mais toujours schématiquement, un autre mode de réalisation d'un plot de connexion selon l'invention;
- les figures 4 et 5 illustrent plus en détail mais toujours schématiquement un mode de réalisation d'une structure de renfort selon l'invention; et
- la figure 6 illustre un autre mode de réalisation d'un motif discontinu équipant une structure de renfort selon l'invention.

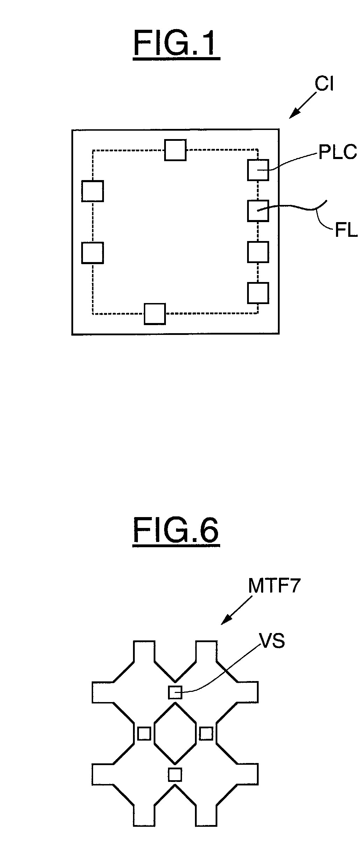

Sur la figure 1, la référence CI désigne un circuit intégré comportant, comme il est classique en la matière, des composants électroniques (transistors, ...) en zone centrale du substrat de silicium, et, à la périphérie de la puce, des plots de connexion PLC sur chacun desquels sera soudé un fil de connexion FL, généralement en or. Le fil de connexion est destiné à être soudé par ailleurs sur une patte métallique d'un grille. Puis, le tout est encapsulé dans un boîtier en résine pour former le composant prêt à être soudé sur une carte électronique.

Les plots de connexion PLC forment en fait les bornes d'entrée/sortie du circuit intégré CI.

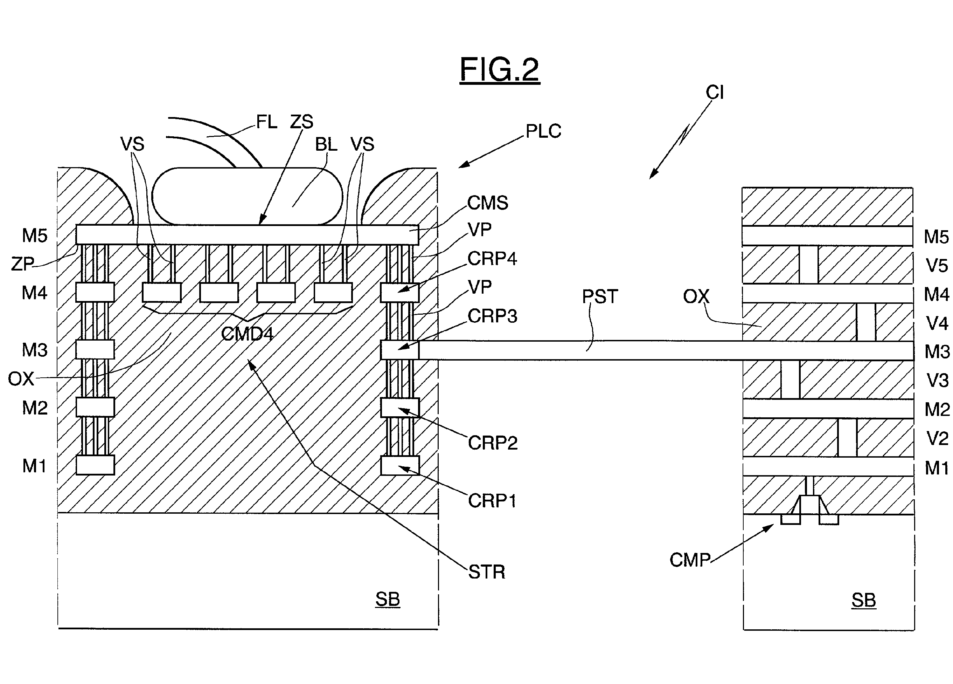

Sur la figure 2, on a représenté schématiquement une coupe verticale du circuit intégré avec, en partie gauche, l'architecture interne d'un plot de connexion PLC, et en partie droite les différents niveaux de métallisation et de vias du circuit intégré destinés à connecter entre eux les différents composants électroniques CMP du circuit intégré.

Sur la figure 2, certaines dimensions ont été volontairement exagérées, d'autres volontairement réduites, à des fins de simplification et de clarté du dessin.

Dans cet exemple, on suppose, à titre indicatif, que le circuit intégré comporte cinq niveaux de métallisation M1-MS et quatre niveaux de vias V2-V5. L'homme du métier sait qu'un via est un plot d'interconnexion métallique destiné à relier deux pistes situées à deux niveaux de métallisation adjacents.

Par ailleurs, un matériau isolant OX, par exemple du dioxyde de silicium, isole classiquement les différents vias entre eux ainsi que les différents niveaux de métallisation entre eux. Par ailleurs, de l'oxyde isole également les différentes pistes ou lignes métalliques réalisées au sein de chaque niveau de métallisation. Sur la partie droite de la figure 2, à des fins de simplification, on n'a pas représenté le réseau de pistes et le matériau isolant interpistes correspondant, ménagés au sein de chaque niveau de métallisation.

Sur la partie gauche de la figure 2, on voit que le plot de connexion PLC comporte une couche métallique supérieure continue CMS située au niveau de métallisation supérieure du circuit intégré, ici le niveau de métallisation M5. Cette couche métallique supérieure continue présente sur sa face supérieure une zone ZS pour le soudage d'un fil de connexion FL par l'intermédiaire d'une boule d'or BL. Ce sont les contraintes appliquées sur la boule BL lors de l'opération de soudage qui peuvent provoquer un risque d'apparition de microfissures dans le plot de connexion et entraîner un risque de délamination, c'est-à-dire un risque de décollement de la couche métallique supérieure CMS par rapport à l'oxyde sous-jacent. La structure selon l'invention que l'on va maintenant décrire pour ce plot de connexion, va permettre de minimiser, voire de supprimer ce risque, et ce même pour des technologies avancées, par exemple des technologies 0,18 µm et moins.

Selon l'invention, on dispose à cet égard une structure de renfort sous la zone de soudage. Cette structure de renfort STR comporte au moins une couche métallique discontinue CMD4 située au niveau de métallisation immédiatement inférieur, c'est-à-dire en l'espèce au niveau de métallisation M4.

La structure de renfort STR comporte par ailleurs des vias métalliques VS reliant cette couche métallique discontinue CMD4 à la surface inférieure de la couche métallique supérieure CMS.

Par ailleurs, la structure de renfort comporte un enrobage isolant OX, par exemple du dioxyde de silicium, enrobant la couche métallique discontinue CMD4 ainsi que ses discontinuités et les espaces intervias entre la couche CMD4 et la couche métallique supérieure CMS.

Dans l'exemple illustré sur la figure 2, dans lequel la structure de renfort ne comporte qu'une seule couche métallique discontinue CMD4, l'enrobage isolant OX s'étend jusqu'à la surface supérieure du substrat SB et est formé des différentes couches d'oxyde interlignes et intervias classiquement utilisées dans la fabrication des circuits intégrés.

Le fait de n'avoir qu'une seule couche métallique discontinue CMD4 offre l'avantage de présenter un plot de connexion PLC ayant une valeur capacitive entre le plot et le substrat SB relativement faible, ce qui est particulièrement avantageux dans des applications radiofréquence.

Par ailleurs, le plot de connexion PLC comporte une couronne périphérique métallique CRP4 située au même niveau de métallisation que celui de la couche métallique discontinue CMD4, c'est-à-dire au niveau de métallisation M4. Cette couronne métallique CRP4 entoure la couche métallique discontinue CMD4 et est électriquement isolée de celle-ci par l'enrobage isolant OX. Par ailleurs, des vias périphériques métalliques VP relient cette couronne métallique CRP4 à une zone périphérique ZP de la surface inférieure de la couche métallique supérieure CMS.

Alors qu'il serait tout à fait envisageable de ne prévoir qu'une seule couronne métallique CRP4, il est néanmoins avantageux que le plot de connexion PLC comporte plusieurs couronnes métalliques CRP1, CRP2, CRP3, CRP4, empilées, et s'étendant respectivement à des niveaux de métallisation différents, en l'espèce aux niveaux de métallisation M1, M2, M3 et M4. Chaque couronne périphérique est reliée à la couronne immédiatement adjacente par des vias périphériques métalliques VP, qui sont donc situés à des niveaux de vias différents.

Ainsi, il est possible de connecter le plot de connexion PLC aux différents composants CMP du circuit intégré, à n'importe quel niveau de métallisation en fonction du schéma d'implantation des différentes pistes du circuit intégré. A titre d'exemple, sur la figure 2, on a représenté une piste PST qui se situe au niveau de métallisation M3 et qui vient contacter la couronne métallique CRP3, de façon à créer une liaison électrique entre le plot de contact PLC et certains des composants du circuit intégré.

Bien que le mode de réalisation illustré sur la figure 2 conduise à un plot de connexion particulièrement bien adapté à des applications radiofréquence, il peut également servir à d'autres applications. Ceci évite d'utiliser des plots de connexion ayant des structures différentes en fonction des applications.

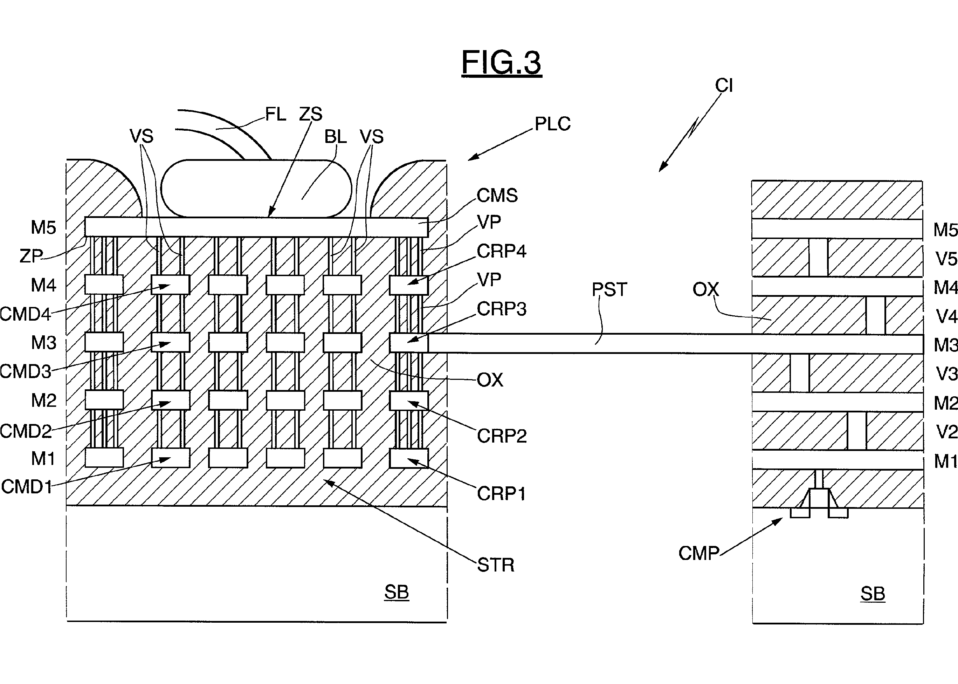

Il est également envisageable que la structure de renfort STR comporte, comme illustré sur la figure 3, plusieurs couches métalliques discontinues empilées CMD1, CMD2, CMD3, CMD4 et mutuellement reliées par des vias métalliques VS. L'enrobage isolant OX enrobe alors en outre chaque couche métallique discontinue et ses discontinuités ainsi que les espaces intervias entre deux couches métalliques discontinues adjacentes.

Les discontinuités de chaque couche métallique discontinue peuvent être réalisées de différentes façons et peuvent avoir des dimensions différentes, avec toutefois un espacement minimal entre deux discontinuités correspondant à la distance minimale séparant deux lignes adjacentes dans la technologie utilisée. Ainsi, pour une technologie 0,18 µm, la largeur minimum d'une discontinuité sera de 0,32 µm.

Ceci étant, la figure 4 illustre un mode de réalisation d'une telle couche métallique discontinue. Sur cette figure 4, on voit que la couche métallique discontinue CMD4, qui est entourée par la couronne périphérique CRP4, est formée d'un motif régulièrement réparti. En l'espèce, chaque motif MTFi est ici formé de plusieurs bandes métalliques parallèles (quatre par exemple) BD1-BD4 distinctes. Chaque bande métallique supporte plusieurs vias métalliques distincts et parallèles VS (ici quatre). A titre d'exemple, les bandes métalliques d'un motif ont une largeur de 1 µm, une longueur de 7 µm et sont espacées de 1 µm. Par ailleurs, la largeur des vias métalliques VS est de 0,32 µm et ceux-ci sont espacés d'environ 1,5 µm.

Afin de ne pas conférer une direction privilégiée aux discontinuités de la couche métallique discontinue, et minimiser ainsi le risque de cisaillement lors de l'opération de soudage assistée par ultrasons, il est préférable, comme illustré sur la figure 4, que les orientations générales respectives de deux motifs adjacents soient différentes, par exemple orthogonales.

Plus précisément, comme illustré sur la figure 4, sur laquelle on a représenté à des fins de simplification uniquement quatre motifs MTF1, MTF2, MTF3 et MTF4, on voit que la direction générale du motif MTF2 est orthogonale à celle du motif MTF1, ainsi qu'à celle du motif MTF4. De même, la direction générale du motif MTF3 est orthogonale à celle du motif MTF1 et à celle du motif MTF4.

En ce qui concerne la couronne métallique CRP4, celle-ci est équipée, à titre d'exemple, d'une matrice de vias périphériques VP régulièrement répartie sur cette couronne périphérique CRP4.

Par ailleurs, lorsque le plot de connexion comporte plusieurs couches métalliques discontinues adjacentes situées à des niveaux de métallisation différents, il est également préférable, toujours pour minimiser le risque de cisaillement, que deux motifs superposés appartenant respectivement à deux couches métalliques discontinues adjacentes, aient des orientations générales respectives différentes, par exempe orthogonales.

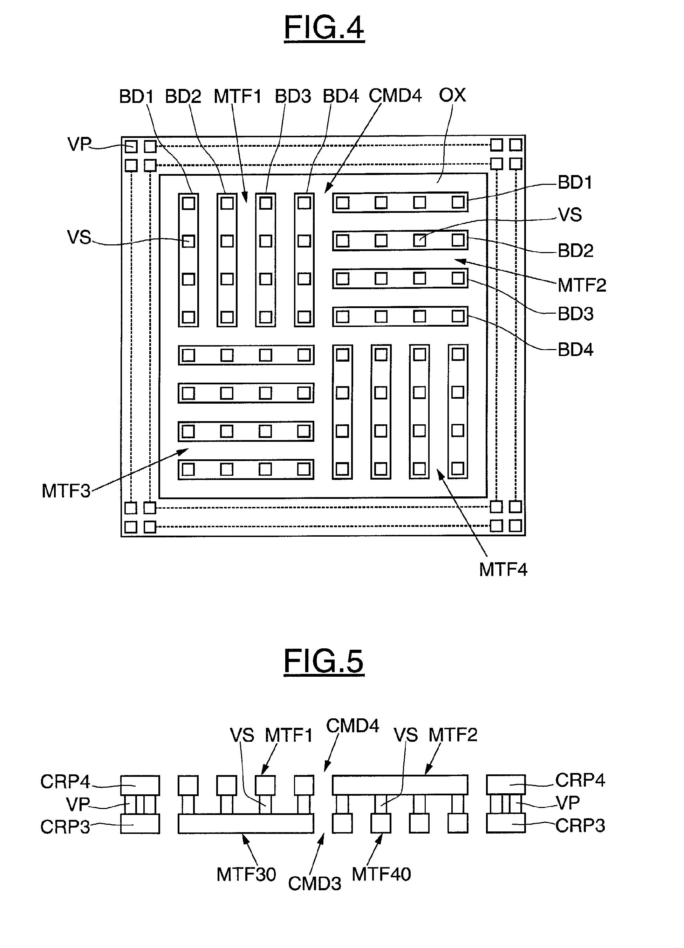

Plus précisément, comme illustré sur la figure 5, on voit que la direction générale du motif MTF1 de la couche CMD4 a une direction générale orthogonale à celle du motif MTF30 de la couche CMD3 (le motif MTF30 étant analogue au motif MTF3). De même, la direction générale du motif MTF2 de la couche CMD4 est orthogonale à celle du motif MTF40 qui est analogue au motif MTF4.

Bien entendu, l'invention n'est pas limitée à ce type de motifs discontinus. Ainsi, par exemple, on peut envisager le motif MTF7 illustré sur la figure 6, qui comporte quatre étoiles aux quatre intersections desquelles on dispose les vias métalliques VS. Dans le cas où plusieurs couches métalliques discontinues seraient utilisées, les motifs peuvent être décalés d'une couche à l'autre, de façon que les orifices centraux de deux motifs superposés ne coïncident pas.

En pratique, les couches métalliques peuvent être en aluminium et les vias en tungstène. Leur réalisation est alors classique. Plus précisément, les couches discontinues résultent d'une gravure de l'aluminium.

En variante, les lignes métalliques et les vias du circuit intégré peuvent être en cuivre. Dans ce cas, les couches métalliques discontinues et les vias sont classiquement réalisés par exemple par un procédé damascène bien connu de l'homme du métier, consistant à déposer l'oxyde OX puis à le graver et à remplir les cavités par le cuivre avant d'effectuer un polissage mécano-chimique.

Cependant, avec une telle variante de réalisation, il est préférable que la densité de cuivre au niveau des couches métalliques discontinues soit comprise entre environ 20% et environ 80% dans une fenêtre de 50 µm x 50 µm, de façon à éviter soit une mauvaise planéité du circuit intégré entre le bord de la puce et le coeur de celle-ci, soit un creusement des zones de cuivre.

Une telle densité de métal est également préférable lorsque les couches métalliques sont en aluminium.

## Revendications

1. Circuit intégré comprenant plusieurs niveaux de métallisation ainsi que des plots de connexion, **caractérisé par le fait que** chaque plot de connexion (PLC) comporte
- une couche métallique supérieure continue (CMS) située au niveau de métallisation supérieur et comportant sur sa face supérieure une zone pour le soudage d'un fil de connexion, et
- une structure de renfort (STR) située sous la zone de soudage et comportant au moins une couche métallique discontinue (CMD4) située au niveau de métallisation immédiatement inférieur, des vias métalliques (VS) reliant cette couche métallique discontinue à la surface inférieure de la couche métallique supérieure, et un enrobage isolant (OX) enrobant ladite couche métallique discontinue et ses discontinuités ainsi que les espaces intervias entre ces deux couches métalliques.

2. Circuit intégré selon la revendication 1, **caractérisé par le fait que** la couche métallique discontinue est formée de motifs élémentaires discontinus régulièrement répartis (MTF1-MTF4).

3. Circuit intégré selon la revendication 2, **caractérisé par le fait que** les orientations générales respectives de deux motifs adjacents (MTF1, MTF2) sont différentes, par exemple orthogonales.

4. Circuit intégré selon l'une des revendications 2 ou 3, **caractérisé par le fait que** chaque motif est formé de plusieurs bandes métalliques distinctes parallèles (BDi), et **par le fait que** chaque bande métallique supporte plusieurs vias métalliques distincts.

5. Circuit intégré selon l'une des revendications précédentes, **caractérisé par le fait que** la couche métallique supérieure (CMS) comporte sur sa surface inférieure une zone périphérique (ZP), **par le fait que** le plot de connexion comporte une couronne périphérique métallique (CRP4) située au même niveau de métallisation que celui de la couche métallique discontinue (CMD4), entourant cette couche métallique discontinue et électriquement isolée de celle-ci par l'enrobage isolant (OX), et des vias périphériques métalliques reliant la zone périphérique de la couche métallique supérieure à ladite couronne périphérique.

6. Circuit intégré selon la revendication 5, **caractérisé par le fait que** le plot comporte plusieurs couronnes périphériques métalliques empilées (CRP1-CRP4) et s'étendant respectivement à des niveaux de métallisation différents, chaque couronne périphérique étant reliée à la couronne immédiatement adjacente par des vias périphériques métalliques.

7. Circuit intégré selon l'une des revendications précédentes, **caractérisé par le fait que** la structure de renfort (STR) comporte plusieurs couches métalliques discontinues empilées (CMD1-CMD4) et s'étendant respectivement à des niveaux de métallisation différents et mutuellement reliées par des vias métalliques, l'enrobage isolant (OX) enrobant en outre chaque couche métallique discontinue et ses discontinuités ainsi que les espaces intervias entre deux couches métalliques discontinues adjacentes.

8. Circuit intégré selon la revendication 7, prise en combinaison avec la revendication 2 ou 3, **caractérisé par le fait que** deux motifs superposés (MTF1, MTF30) appartenant respectivement à deux couches métalliques discontinues adjacentes sont mutuellement décalés ou ont des orientations générales respectives différentes, par exemple orthogonales.

9. Circuit intégré selon l'une des revendications précentes, **caractérisé par le fait que** les couches métalliques sont en aluminium et les vias en tungstène.

10. Circuit intégré selon l'une des revendications 1 à 8, **caractérisé par le fait que** les couches métalliques et les vias sont en cuivre, et **par le fait que** la discontinuité de chaque couche métallique discontinue est choisie de telle sorte que la densité de cuivre soit comprise entre environ 20% et environ 80% dans une fenêtre de 50 µm x 50 µm environ.
